# EUROPÄISCHE PATENTSCHRIFT

(11) **EP 0 255 174 B1**
(45) Veröffentlichungstag und Bekanntmachung des Hinweises auf die Patenterteilung: **13.10.1993**
(21) Anmeldenummer: 87201393.3
(22) Anmeldetag: 21.07.1987
(51) Int. Cl.: H03J 5/24

(54) **Rundfunkempfänger**
Radio receiver
Récepteur radio

(30) Priorität: 29.07.1986 AT 2041/86
(43) Veröffentlichungstag der Anmeldung: 03.02.1988
(73) Patentinhaber: Philips Electronics N.V., 5621 BA Eindhoven (NL)
(72) Erfinder: Fischer, Walter, NL-5656 AA Eindhoven (NL); Süss, Christian, NL-5656 AA Eindhoven (NL)
(74) Vertreter: Schoonheijm, Harry Barend

(56) Entgegenhaltungen:
- FR-A- 1 248 494
- US-A- 2 038 294
- US-A- 3 440 545

## Beschreibung

Die Erfindung betrifft einen Rundfunkempfänger, der zwischen mindestens zwei Wellenbereichen umschaltbar ist, von welchen ein Wellenbereich niedrigere Frequenzen umfaßt als der andere Wellenbereich, und der mindestens zwei durch je ein Paket eines Drehkondensators abstimmbare Parallelresonanzkreise aufweist, von welchen einer als Selektionskreis und der andere als Oszillatorkreis wirksam ist, wobei an die Wicklung der Spule des Oszillatorkreises eine weitere Spulenwicklung induktiv angekoppelt ist.

Bei einem derartigen bekannten Rundfunkempfänger ist die weitere Spulenwicklung durch eine Ankopplungswicklung an die Wicklung der Spule des Oszillatorkreises gebildet, wobei ein zu ihr parallel liegende Kondensator nicht nur bei einem die höheren Frequenzen umfassenden Wellenbereich, sondern auch bei einem die niedrigeren Frequenzen umfassenden Wellenbereich zu ihr parallel liegt. Dieser parallel zur Ankopplungswicklung liegende Kondensator dient dabei zur Bereichsbegrenzung der Wellenbereiche, bei welchen es sich um einen Mittelwellenbereich und einen Langwellenbereich handelt. Hiebei wird der Kapazitätswert dieses parallel zur Ankopplungswicklung liegenden Kondensators entsprechend dem Quadrat des Übersetzungsverhältnisses zwischen der Ankopplungswicklung und der Wicklung der Spule des Oszillatorkreises in denselben transformiert. Diese Maßnahme dient dazu, daß ein Kondensator mit größerem Kapazitätswert verwendet werden kann, als wenn dieser Kondensator unmittelbar parallel zum Drehkondensatorpaket des Oszillatorkreises geschaltet ist, wodurch das vielfach Schwierigkeiten bereitende Vorsehen von Kondensatoren mit nur kleinem Kapazitätswert vermieden wird.

Die Erfindung hat sich zum Ziel gesetzt, bei einem Rundfunkempfänger der eingangs angeführten Gattung eine Umschaltung zwischen zwei Wellenbereichen vorzusehen, die das Erreichen vorgegebener Frequenzbereiche der beiden Wellenbereiche auf einfache Weise ermöglicht und einen guten Gleichlauf bei der Abstimmung innerhalb der beiden Wellenbereiche gewährleistet. Erfindungsgemäß ist hiezu vorgesehen, daß ein erster Kondensator in Serie mit dieser weiteren Spulenwicklung liegt, daß ein Ende dieser Serienschaltung mit einem Ende der Spule des Oszillatorkreises verbunden ist, daß mit dieser Verbindung auch die Wurzel eines Umschalters verbunden ist, daß der Kontakt des Umschalters, der beim Umschalten auf den höhere Frequenzen umfassenden Wellenbereich dient, mit dem anderen Ende der obengenannten Serienschaltung verbunden ist, daß mit dieser Verbindung auch ein Ende des Drehkondensators verbunden ist, und daß der Kontakt des Umschalters, der zum Umschalten auf den niedrigere Frequenzen umfassenden Wellenbereich dient, mit dem Ende eines zweiten Kondensators verbunden ist, dessen anderes Ende mit dem zweiten Ende des Drehkondensators sowie dem weiteren Ende der Spule des Oszillatorkreises verbunden ist. Auf diese Weise wird mit einem einfachen Umschalter in den beiden Wellenbereichen eine Doppelausnützung der weiteren Spulenwicklung und des zu ihr bei dem die höheren Frequenzen umfassenden Wellenbereiches parallel liegenden Kondensators erreicht, wodurch bei der Wellenbereichsumschaltung keine zusätzlichen Schaltungselemente erforderlich sind. Durch die Serienschaltung der weiteren Spulenwicklung zur Wicklung der Spule des Oszillatorkreises wird dabei der die niedrigeren Frequenzen umfassende Wellenbereich bereichsmäßig erweitert und innerhalb dieses Wellenbereiches ein guter Gleichlauf dadurch erreicht, daß der bei dem die höheren Frequenzen umfassenden Wellenbereich parallel zur weiteren Spulenwicklung liegende Kondensator nunmehr in Serie zum im Oszillatorkreis liegenden Drehkondensatorpaket geschaltet ist, wobei er einen Padding-Kondensator bekannter Funktionsweise bildet. Damit ist ein solcher Schaltungsaufbau einfach und preisgünstig.

Es hat sich als vorteilhaft erwiesen, wenn die beide Wicklungen in einer Wicklung mit Anzapfung zusammengefaßt sind, wobei eine Seite dieser Wicklung, von der Anzapfung her gesehen, die Wicklung der Spule des Oszillatorkreises darstellt, und die andere Seite die weitere Spulenwicklung darstellt, und an das freie Ende dieses Wicklungsteiles der zweite Kondensator angeschlossen ist. Auf diese Weise wird ein sehr einfacher Aufbau erhalten, da eine angezapfte Wicklung einfacher und preisgünstiger herzustellen ist als eine als eigene Spulenwicklung ausgebildete weitere Spulenwicklung.

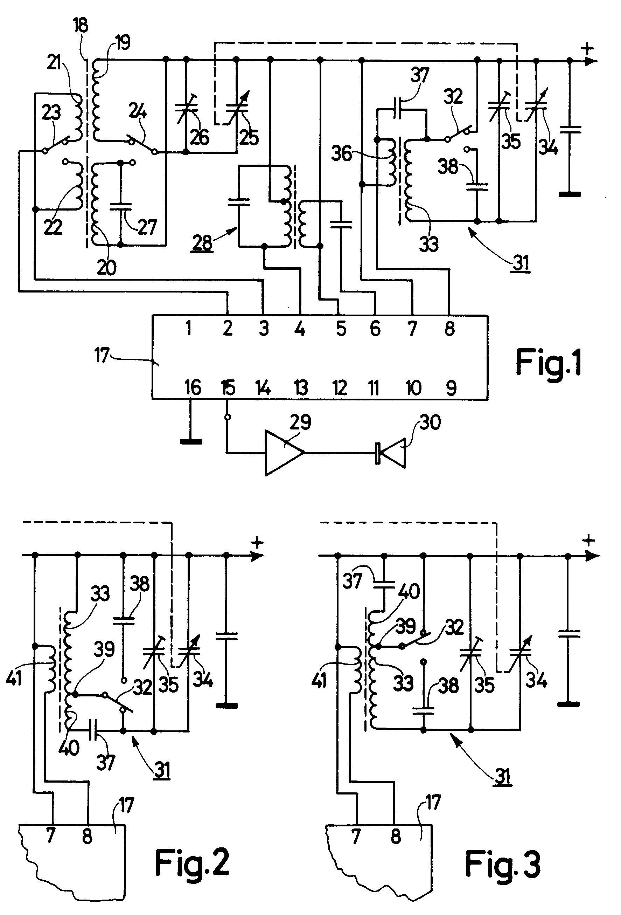

Die Erfindung wird im folgenden anhand der Zeichnung, in der in Form von Schaltbildern einige Ausführungsbeispiele der Erfindung dargestellt sind, auf die sie jedoch nicht beschränkt sein soll, näher erläutert. Fig.1 zeigt das Schaltbild eines zwischen einem Mittelwellenbereich und einem Langwellenbereich umschaltbaren Rundfunkempfängers, wobei die an die Wicklung der Spule des Oszillatorkreises angekoppelte Ankopplungswicklung zusätzlich im Zuge der Wellenbereichsumschaltung ausgenützt wird. Fig.2 zeigt als Ausschnitt des Schaltbildes nach Fig.1 einen Oszillatorkreis, wobei die Wicklung der Spule desselben mit einer Anzapfung versehen ist und ein von derselben ausgehender Wicklungsteil über einen Kondensator zu dem vom Bezugspotential abgewandten Ende des Oszillatorkreises geführt ist. Fig.3 zeigt in Abwandlung des Ausführungsbeispieles nach Fig.2 eine Ausführungsform eines Oszillatorkreises, bei dem der von der Anzapfung der Wicklung der Spule des Oszillatorkreises ausgehende Wicklungsteil über einen Kondensator zum Bezugspotential geführt ist.

In Fig.1 ist mit 17 eine integrierte Schaltung bezeichnet, welche zur Verarbeitung von Hochfrequenz- und Zwischenfrequenzsignalen für einen Rundfunkempfänger zum Empfang von amplitudenmodulierten oder frequenzmodulierten Signalen ausgebildet ist. Eine solche integrierte Schaltung ist im Handel unter der Typenbezeichnung TEA 5570 erhältlich. Im vorliegenden Fall ist nur derjenige Teil dieser integrierten Schaltung ausgenützt, der zur Verarbeitung von amplitudenmodulierten Signalen dient. Der Rundfunkempfänger ist zwischen zwei Wellenbereichen umschaltbar, und zwar im vorliegenden Fall einem Mittelwellenbereich und einem Langwellenbereich. Zum Empfang der Signale in diesen beiden Wellenbereichen ist hier eine Ferritstabantenne vorgesehen, die in Fig.1 durch die strichlierte Linie 18 angedeutet ist. Auf dieser Ferritstabantenne ist eine Wicklung 19 einer Spule zum Mittelwellenempfang und eine Wicklung 20 einer Spule zum Langwellenempfang angeordnet. An die Wicklungen 19 und 20 dieser beiden Spulen ist je eine Ankopplungswicklung 21 bzw. 22 angekoppelt. Diese Ankopplungswicklungen 21 und 22 snd mit einem Ende miteinander verbunden und zum Anschluß 3 der integrierten Schaltung 17 geführt. Die anderen Enden der beiden Ankopplungswicklungen 21 und 22 sind je an einen Kontakt eines Umschalters 23 angeschlossen, dessen Wurzel mit dem Anschluß 2 der integrierten Schaltung 17 verbunden ist. Die Wicklungen 19 und 20 der beiden auf der Ferritstabantenne vorgesehenen Spulen sind mit einem Ende mit dem Bezugspotential, im vorliegenden Fall dem positiven pol der Versorgungsspannung, verbunden und ihre anderen Enden sind je an einen Kontakt eines weiteren Umschalters 24 angeschlossen, dessen Wurzel mit einem Paket 25 eines Drehkondensators in Verbindung steht, der ebenfalls zum Bezugspotential führt. Wie üblich, sind hiedurch zwei abstimmbare, als Selektionkskreise wirksame Parallelresonanzkreise gebildet, zwischen welchen mit den Umschaltern 23 und 24 umgeschaltet werden kann, wobei in Fig.1 die Schalterstellungen für den Mittelwellenempfang gezeigt sind. In ebenfalls üblicher Weise ist zum Bereichsabgleich parallel zum Paket 25 des Drehkondensators noch ein Trimmer 26 und zur Bereichsverschiebung von Mittelwelle auf Langwelle parallel zur Wicklung 20 der Spule für den Langwellenempfang noch ein Kondensator 27 geschaltet.

Die den Anschlüssen 2 und 3 der integrierten Schaltung 17 zugeführten Hochfrequenzsignale werden in üblicher Weise in einer in derselben vorgesehenen Mischstufe in ein Zwischenfrequenzsignal umgewandelt,das vom Anschluß 4 der integrierten Schaltung 17 her einem Zwischenfrequenz-Selektionskreis 28 zugeführt und über den Anschluß 6 der integrierten Schaltung 17 wieder in diese eingekoppelt wird, wonach es in derselben demoduliert wird. Das auf diese Weise gewonnene Niederfrequenzsignal steht am Anschluß 15 der integrierten Schaltung 17 zur Verfügung, von wo es einem Verstärker 29 und schließlich einem Lautsprecher 30 zugeführt wird. Dieser Niederfrequenzteil des Rundfunkempfängers kann beispielsweise auch noch einen Lautstärkeregler und eine Tonblende enthalten, die hier nicht näher dargestellt sind.

Zur Gewinnung des Zwischenfreguenzsignals in der in der integrierten Schaltung 17 enthaltenen Mischstufe ist dieser in üblicher weise ein Oszillatorsignal zuzuführen, das in einem ebenfalls in der integrierten Schaltung 17 enthaltenen Oszillator gewonnen wird. Hiezu ist an die Anschlüsse 7 und 8 der integrierten Schaltung 17 ein abstimmbarer Oszillatorkreis 31 angeschlossen, der mit einem weiteren Umschalter 32 zwischen Mittelwellenempfang und Langwellenempfang umschaltbar ist. Dieser Oszillatorkreis 31 weist eine Spule mit der Wicklung 33 und ein weiteres Paket 34 des Drehkondensators auf, wobei zu letzterem ebenfalls ein Trimmer 35 parallel geschaltet ist. An die Wicklung 33 der Spule des Oszillatorkreises 31 ist induktiv eine weitere Spulenwicklung angekoppelt, die im vorliegenden Fall durch eine Ankopplungswicklung 36 an den in der integrierten Schaltung 17 enthaltenen Oszillator gebildet ist. Demgemäß steht diese Ankopplungswicklung 36 mit den Anschlüssen 7 und 8 der integrierten Schaltung in Verbindung. Ein Ende der Ankopplungswicklung 36 und je ein Anschluß des Paketes 34 des Drehkondensators und des Trimmers 35 sind mit dem Bezugspotential verbunden.

Weiters ist zur Wicklung 37 der Spule des Oszillatorkreises 31 ein Kondensator 37 und zu diesem die die weitere Spulenwicklung bildende Ankopplungswicklung 36 in Serie geschaltet, die dann ihrerseits mit dem Bezugspotential in Verbindung steht. Schließlich ist mit der Verbindung der Wicklung 33 der Spule des Oszillatorkreises 31 mit dem zu ihr in Serie liegenden Kondensator 37 die Wurzel des weiteren Umschalters 32 verbunden, an dessen einen Kontakt das Bezugspotential und an dessen anderen Kontakt ein weiterer Kondensator 38 angeschlossen ist, der mit seinem anderen Anschluß an die Verbindung des Paketes 34 des Drehkondensators mit der Wicklung 33 der Spule des Oszillatorkreises 31 angeschlossen ist.

In der in Fig.1 gezeigten, dem Mittelwellenempfang entsprechenden Stellung der Umschalter 23, 24 und 32 befindet sich von diesen der Umschalter 32 in der Stellung, in der er mit dem Kontakt eine Verbindung herstellt, an den das Bezugspotential angeschlossen ist. Auf diese Weise ist bei Mittelwellenempfang die Verbindung der Wicklung 33 der Spule des Oszillatorkreises 31 mit dem zu ihr in Serie liegenden Kondensator 37 an das Bezugspotential angeschlossen. Dies hat zur Folge, daß der Kondensator 37 parallel zur die weitere Spulenwicklung bildenden Ankopplungswicklung 36 liegt und die Wicklung 33 des Oszillatorkreises 31 ebenso wie dessen Drehkondensatorpaket 34 zum Bezugspotential führt. Damit transformiert sich der Kapazitätswert des Kondensators 37 entsprechend dem Quadrat des Übersetzungsverhältnisses zwischen der Ankopplungswicklung und der Wicklung der Spule des Oszillatorkreises in denselben, wo er dann parallel zum Drehkondensatorpaket 34 wirksam ist und dadurch in bekannter Weise eine Bereichsbegrenzung des Mittelwellenbereiches bewirkt. Durch die Transformation des Kapazitätswertes des Kondensators 37 ist dabei der Kondensator 37 vorteilhafterweise mit einem größeren Kapazitätswert zu dimensionieren, als wenn er direkt parallel zum Drehkondensatorpaket 34 geschaltet wäre.

In der anderen, dem Langwellenempfang entsprechenden Stellung der Umschalter 23, 24 und 32 ist von diesen der Umschalter 32 mit jenem Kontakt verbunden, an den der weitere Kondensator 38 angeschlossen ist, was zur Folge hat, daß dieser Kondensator 38 an die Verbindung der Wicklung 33 der Spule des Oszillatorkreises 31 mit dem zu ihr in Serie liegenden Kondensator 37 angeschlossen ist, dies unter Aufhebung des Anschlusses dieser Verbindung an das Bezugspotential wie es bei Mittelwellenempfang der Fall war. Hiedurch ist nun erreicht, daß die die weitere Spulenwicklung bildende Ankopplungswicklung 36 wirkungsmäßig in Serie zur Wicklung 33 der Spule des Oszillatorkreises 31 liegt, wodurch sich die im Oszillatorkreis 31 wirksame Induktivität vergrößert, was eine bereichsmäßige Erweiterung des Langwellenbereiches ergibt. Weiters ist hiedurch erreicht, daß der Kondensator 37 nunmehr wirkungsmäßig in Serie zum im Oszillatorkreis 31 liegenden Drehkondensatorpaket 34 geschaltet ist, wodurch er die Funktion eines padding-Kondensators übernimmt und so einen guten Gleichlauf innerhalb des Langwellenbereiches bewirkt. Schließlich ist noch erreicht, daß der Kondensator 38 parallel zur Wicklung 33 der Spule des Oszillatorkreises 31 liegt, was bedeutet, daß sein Kapazitätswert in den Oszillatorkreis 31 transformiert wird und so parallel zum Drehkondensatorpaket 34 im Oszillatorkreis 31 wirksam wird, wodurch in bekannter Weise die erforderliche Bereichsverschiebung von Mittelwelle auf Langwelle erreicht wird.

Auf diese einfache Weise läßt sich ohne zusätzliche Schaltungselemente beispielsweise ein Mittelwellenbereich von 512KHz bis 1632KHz und ein Langwellenbereich von 147KHz bis 285KHz realisieren, dies bei gutem Gleichlauf auch im Langwellenbereich zufolge der bekannten Wirkung eines PaddingKondensators. Selbstverständlich sind die vorstehend angeführten Maßnahmen auch bei der Umschaltung zwischen anderen Wellenbereichen als Mittelwelle und Langwelle anwendbar, wie beispielsweise bei der Umschaltung zwischen zwei Kurzwellenbereichen. Ebenso könnte der den Oszillatorkreis 31 umschaltende Umschalter 32 bei vom Prinzip her gleicher Funktionsweise auch noch anders in den Oszillatorkreis aufgenommen sein, dergestalt, daß seine Wurzel mit dem Bezugspotential in Verbindung steht und an einem seiner Kontakte die Verbindung der Wicklung 33 der Spule des Oszillatorkreises mit dem zu ihr in Serie liegenden Kondensator 37 und an den anderen Kontakt wieder der weitere Kondensator 38 angeschlossen ist, der dann bei Langwellenempfang unmittelbar parallel zum Drehkondensatorpaket 34 im Oszillatorkreis 31 zu liegen kommt.

Bei dem Ausführungsbeispiel nach Fig.2 ist die Wicklung 33 der Spule des Oszillatorkreises 31 mit einer Anzapfung 39 versehen, wobei der von dieser Anzapfung ausgehende Wicklungsteil 40 die weitere Spulenwicklung bildet, die dabei wieder induktiv an die Wicklung 33 der Spule des Oszillatorkreises angekoppelt ist. An das freie Ende dieses Wicklungsteiles 40 ist der Kondensator 37 angeschlossen, der mit seinem anderen Anschluß mit dem im Oszillatorkreis 31 liegenden Drehkondensatorpaket 34 in Verbindung steht. Der Umschalter 32 ist hier so in den Oszillatorkreis 31 aufgenommen, daß seine Wurzel an die Anzapfung 39 der Wicklung 33 der Spule des Oszillatorkreises angeschlossen ist, einer seiner Kontakte mit der Verbindung des Kondensators 37 mit dem Drehkondensatorpaket 34 in Verbindung steht und an seinen anderen Kontakt der Kondensator 38 angeschlossen ist, der seinerseits, ebenso wie die Wicklung 33 der Spule des Oszillatorkreises 31 und dessen Drehkondensatorpaket 34, zum Bezugspotential führt. Zur Ankopplung des Oszillatorkreises 31 an die integrierte Schaltung 17 ist hier eine separate Ankopplungswicklung 41 vorgesehen, die ebenfalls induktiv mit der Wicklung 33 der Spule des Oszillatorkreises 31 gekoppelt ist, die hier aber im Zuge der wellenbereichsumschaltung nicht weiter verwendet wird. Falls erwünscht und im Hinblick auf die integrierte Schaltung 17 zulässig, könnte anstelle einer solchen separaten Ankopplungswicklung auch eine weitere Anzapfung an der Wicklung 33 der Spule des Oszillatorkreises vorgesehen werden.

In der in Fig.2 gezeigten, dem Mittelwellenempfang entsprechenden Stellung des Umschalters 32 stellt dieser eine Verbindung zwischen der Anzapfung 39 und der Verbindung des Kondensators 37 mit dem Drehkondensatorpaket 34 her. Auf diese Weise ist der Kondensator 37 parallel zum die weitere Spulenwicklung bildenden Wicklungsteil 40 geschaltet und das vom Bezugspotential abgewandte, durch die Anzapfung 39 gebildete Ende der Wicklung 33 des Oszillatorkreises 31 ist mit dem ebenfalls vom Bezugspotential abgewandten Anschluß des Drehkondensatorpaketes 34 im Oszillatorkreis 31 verbunden. Damit transformiert sich wieder der Kapazitätswert des Kondensators 37 entsprechend dem Quadrat des Übersetzungsverhältnisses zwischen dem Wicklungsteil 40 und der Wicklung 33 der Spule des Oszillatorkreises 31 in denselben, wo er dann parallel zum Drehkondensatorpaket 34 wirksam ist und dadurch wieder eine Bereichsbegrenzung des Mittelwellenbereiches bewirkt.

In der anderen, dem Langwellenempfang entsprechenden Stellung des Umschalters 32 stellt dieser nunmehr eine Verbindung der Anzapfung 39 mit dem Kondensator 38 her,wodurch der Kondensator 38 parallel zur Wicklung 33 der Spule des Oszillatorkreises 31 liegt, was wieder bedeutet, daß sein Kapazitätswert in den Oszillatorkreis transformiert wird und so parallel zum Drehkondensatorpaket 34 im Oszillatorkreis 31 wirksam wird, wodurch die erforderliche Bereichsverschiebung von Mittelwelle auf Langwelle erreicht wird. Weiters ist erreicht, daß nunmehr der die weitere Spulenwicklung bildende Wicklungsteil 40 in Serie zur Wicklung 33 der Spule des Oszillatorkreises 31 liegt, wodurch sich wieder die im Oszillatorkreis wirksame Induktivität vergrößert, was eine bereichsmäßige Erweiterung des Langwellenbereiches ergibt.

Außerdem liegt nunmehr der Kondensator 37 in Serie zum im Oszillatorkreis 31 liegenden Drehkondensatorpaket 34, wodurch er wieder die Funktion eines Padding-Kondensators übernimmt und so einen guten Gleichlauf innerhalb des Langwellenbereiches bewirkt. Da beim vorliegenden Ausführungsbeispiel der die weitere Spulenwicklung bildende Wicklungsteil 40 und die separate Ankopplungswicklung 41 unabhängig voneinander dimensioniert werden können, besteht mehr Freiheit in der Auslegung der einzelnen Schaltungselemente im Zusammenhang mit dem Erreichen der gewünschten Frequenzbereiche der beiden Wellenbereiche.

Das Ausführungsbeispiel nach Fig.3 unterscheidet sich von demjenigen nach Fig.2 nur dadurch, daß der die weitere Spulenwicklung bildende Wicklungsteil 40 über den Kondensator 37 zum Bezugspotential geführt ist, und an den einen Kontakt des Umschalters 32 das Bezugspotential angeschlossen ist und der an den anderen Kontakt des Umschalters 32 angeschlossene Kondensator 38 zu dem vom Bezugspotential abgewandten Ende des Oszillatorkreises 31 geführt ist. Die Wirkungsweise des Oszillatorkreises dieses Ausführungsbeispieles ist vollkommen analog zu derjenigen des Oszillatorkreises des Ausführungsbeispieles nach Fig.2, nur sind andere Schaltungselemente mit dem Bezugspotential verbunden, was gegebenenfalls vorteilhaft sein kann. Ebenso wie im Zusammenhang mit dem Ausführungsbeispiel nach Fig.1 erwähnt, könnte auch bei den Ausführungsbeispielen nach den Figuren 2 und 3 der Umschalter 32 auch so in den Oszillatorkreis aufgenommen werden, daß er bei Langwellenempfang den Kondensator 38 unmittelbar parallel zum Drehkondensatorpaket 34 im Oszillatorkreis 31 legt. Wie ersichtlich, besteht eine Reihe von Abwandlungsmöglichkeiten der im vorstehenden beschriebenen Ausführungsbeispiele, ohne daß dabei der Rahmen der Erfindung verlassen wird.

## Patentansprüche

1. Rundfunkempfänger, der zwischen mindestens zwei Wellenbereichen umschaltbar ist, von welchen ein Wellenbereich niedrigere Frequenzen umfaßt als der andere Wellenbereich, und der mindestens zwei durch je ein Paket eines Drehkondensators abstimmbare Parallelresonanzkreise aufweist, von welchen einer als Selektionskreis und der andere als Oszillatorkreis wirksam ist, wobei an die Wicklung der Spule des Oszillatorkreises ( 33 ) eine weitere Spulenwicklung ( 36, 40 ) induktiv angekoppelt ist, dadurch gekennzeichnet, daß ein erster Kondensator ( 37 ) in Serie mit dieser weiteren Spulenwicklung ( 36, 40 ) liegt, daß ein Ende dieser Serienschaltung mit einem Ende der Spule des Oszillatorkreises ( 33 ) verbunden ist, daß mit dieser Verbindung auch die Wurzel eines Umschalters ( 32 ) verbunden ist, daß der Kontakt des Umschalters, der beim Umschalten auf den höhere Frequenzen umfassenden Wellenbereich dient, mit dem anderen Ende der obengenannten Serienschaltung verbunden ist, daß mit dieser Verbindung auch ein Ende des Drehkondensators ( 34 ) verbunden ist, und daß der Kontakt des Umschalters ( 32 ), der zum Umschalten auf den niedrigere Frequenzen umfassenden Wellenbereich dient, mit dem Ende eines zweiten Kondensators ( 38 ) verbunden ist, dessen anderes Ende mit dem zweiten Ende des Drehkondensators ( 34 ) sowie dem weiteren Ende der Spule des Oszillatorkreises ( 33 ) verbunden ist.

2. Rundfunkempfänger nach Anspruch 1, dadurch gekennzeichnet, daß beide Wicklungen in einer Wicklung mit Anzapfung ( 33, 40 ) zusammengefaßt sind, wobei eine Seite dieser Wicklung, von der Anzapfung her gesehen, die Wicklung der Spule des Oszillatorkreises ( 33 ) darstellt, und die andere Seite die weitere Spulenwicklung ( 40 ) darstellt, und an das freie Ende dieses Wicklungsteiles der zweite Kondensator ( 38 ) angeschlossen ist.

## Claims

1. A radio receiver which is switchable between at least two waveranges one of which covers frequencies which are lower than those covered by the other, said receiver having at least two parallel resonant circuits which are each tunable by a set of plates of a variable capacitor, one circuit operating as a selection circuit and the other as an oscillator circuit, a further coil winding (36,40) being inductively coupled to the coil winding of the oscillator circuit (33), characterized in that a first capacitor (37) is arranged in series with said further coil winding (36, 40), in that one end of said series arrangement is connected to one end of the coil of the oscillator circuit (33), in that also the center contact of a change-over switch (32) is connected to said connection, in that the contact of the change-over switch used for changing over to the waverange covering higher frequencies is connected to the other end of the above-mentioned series arrangement, in that also one end of the variable capacitor (34) is connected to said connection, and in that the contact of the change-over switch (32) used for changing over to the waverange covering lower frequencies is connected to the end of a second capacitor (38), the other end of which is connected to the second end of the variable capacitor (34) and to the further end of the coil of the oscillator circuit (33).

2. A radio receiver as claimed in Claim 1, characterized in that the two windings are combined to one winding with a tapping (33, 40), while one winding segment, viewed from the tapping, constitutes the coil winding of the oscillator circuit (33) and the other segment constitutes the further coil winding (40), and the second capacitor (38) is connected to the free end of said winding segment.

## Revendications

1. Récepteur radio pouvant être commuté entre au moins deux domaines d'ondes dont l'un a des fréquences plus basses que l'autre et comportant au moins deux circuits résonnants en parallèle pouvant être accordés chacun par un paquet d'un condensateur variable, l'un des circuits servant de circuit de sélection et l'autre, de circuit d'oscillation, un autre enroulement de bobine (36, 40) étant couplé par induction à l'enroulement de la bobine du circuit d'oscillation (33), caractérisé en ce qu'un premier condensateur (37) est monté en série avec cet autre enroulement de bobine (36, 40), une extrémité de ce montage en série est connectée à une extrémité de la bobine du circuit d'oscillation (33), la racine d'un commutateur (32) est également connectée à cette liaison, le contact du commutateur, qui sert lors du passage domaine d'ondes contenant les fréquences supérieures, est connecté à l'autre extrémité du montage série précité, une extrémité du condensateur variable (34) est également connectée à cette liaison et le contact du commutateur (32), qui sert à passer au domaine d'ondes contenant les fréquences inférieures, est connecté à l'extrémité d'un second condensateur (38), dont l'autre extrémité est connectée à la seconde extrémité du condensateur variable (34) ainsi qu'à l'autre extrémité de la bobine du circuit d'oscillation (33).

2. Récepteur radio selon la revendication 1, caractérisé en ce que les deux enroulements sont regroupés dans un seul enroulement doté d'une prise (33, 40), un côté de cet enroulement, vu à partir de la prise, représentant l'enroulement de la bobine du circuit d'oscillation (33) et l'autre côté représentant l'autre enroulement de bobine (40), le second condensateur (38) étant connecté à l'extrémité libre de cette partie d'enroulement.
